# FASCICULE DE BREVET EUROPEEN

(11) **EP 0 746 190 B1**
(45) Date de publication et mention de la délivrance du brevet: **20.01.1999**
(21) Numéro de dépôt: 96401131.6
(22) Date de dépôt: 24.05.1996
(51) Int. Cl.: H05K 7/12, G01D 11/30

(54) **Mouvement pour tableau de bord**
Mechanismus für ein Armaturenbrett
Movement for a dashboard

(30) Priorité: 29.05.1995 FR 9506306
(43) Date de publication de la demande: 04.12.1996
(73) Titulaire: SAGEM SA, 75783 Paris Cédex 16 (FR)
(72) Inventeur: Fournier, Joel, F-95000 Cergy (FR)
(74) Mandataire: Bloch, Gérard

(56) Documents cités:
- EP-A- 0 355 201
- DE-A- 4 336 924
- DE-B- 1 072 284
- DE-U- 9 203 193
- XEROX DISCLOSURE JOURNAL, vol. 16, no. 2, 1 Mars 1991, pages 149-150, XP000200826 SCHROLL R E ET AL: "METHOD OF CONNECTING A THERMOSTAT OR OTHER ELECTRICAL DEVICE"

## Description

Le tableau de bord d'un véhicule automobile comporte des indicateurs fournissant au conducteur diverses informations sur son véhicule.

Ces indicateurs sont en général constitués d'un mouvement comportant une aiguille entraînée en rotation devant un cadran par un champ magnétique engendré par des bobinages de commande.

Le raccordement des bobinages à une carte de circuit imprimé portant le mouvement nécessite un montage assez complexe. En effet, la fragilité du fil des bobinages exclut toute connexion directe de ceux-ci sur la carte, si bien qu'il faut prévoir des broches d'interface sur lesquelles est soudé le fil lors de l'assemblage des constituants du mouvement et qui le protègent mécaniquement.

Ces broches présentent la solidité et la facilité de manipulation voulues pour le raccordement électrique à la carte.

Le raccordement électrique de la broche à la carte nécessite un élément complémentaire, tel qu'un écrou, de la soudure ou autre.

La fixation du mouvement à la carte est assurée par d'autres pièces.

En dehors de leur utilisation indiquée ci-dessus pour la protection mécanique des fils de bobinage, les broches sont aussi employées pour pallier la fragilité d'autres composants électriques du mouvement qui doivent être reliés à la carte et qui ne supporteraient pas les contraintes mécaniques du mouvement sur la carte.

Le coût des nombreux éléments de raccordement, électrique et mécanique, évoqués ci-dessus est important, sans parler de l'inconvénient des difficultés de montage et de la fiabilité limitée.

Par DE-A-43 36 924, était connu un appareil de mesure pour tableau de bord de voiture, avec un mouvement dont les extrémités des fils de bobinage sont reliées à des broches se prolongeant par une douille comportant, intégrées, des zones internes de contact pour recevoir une fiche reliée à un circuit externe.

XEROX Disclosure Journal (vol. 16, N° 2, ler mars 1991) enseigne un connecteur avec deux pattes d'encliquetage dans deux fenêtres d'un circuit imprimé et des lames de contact élastiques, dont les extrémités recourbées viennent en porte-à-faux en appui sur des zones de contact du circuit imprimé.

La présente invention vise à réduire le nombre des éléments de raccordement électrique à la carte.

A cet effet, l'invention concerne un mouvement pour tableau de bord de véhicule, comportant un organe d'entraînement d'un indicateur, relié électriquement à des broches d'interface raccordées à des moyens de connexion agencés pour connecter les broches à des plages de contact respectives d'une carte de circuit imprimé, caractérisé par le fait que les moyens de connexion sont intégrés aux broches et comportent des zones de contact agencées pour venir en appui sur lesdites plages et les broches comportent des moyens d'accrochage à la carte.

Ainsi, au montage sur la carte, les broches, en plus de leur fonction d'interface de protection, assurent l'établissement direct des connexions électriques alimentant le mouvement à partir de la carte, sans nécessité de moyens et d'opérations de montage supplémentaires et la fixation mécanique du mouvement à la carte.

L'invention sera mieux comprise à l'aide de la description suivante de deux exemples utiles à la compréhension et d'une forme de réalisation préférée du mouvement de l'invention, en référence aux figures du dessin annexé, sur lequel :
- la figure 1 est une coupe latérale représentant schématiquement un exemple de réalisation du mouvement monté sur une carte,
- la figure 2 est une coupe latérale détaillée d'une broche d'interface du mouvement de la figure 1 et de son logement,
- la figure 3 est une vue en plan de la broche de la figure 2,
- les figures 4 et 5 sont des vues en coupe représentant une broche du mouvement selon l'invention,
- la figure 6 est une vue latérale en coupe du second exemple de réalisation et
- la figure 7 est une vue de dessous d'une embase du mouvement de la figure 6.

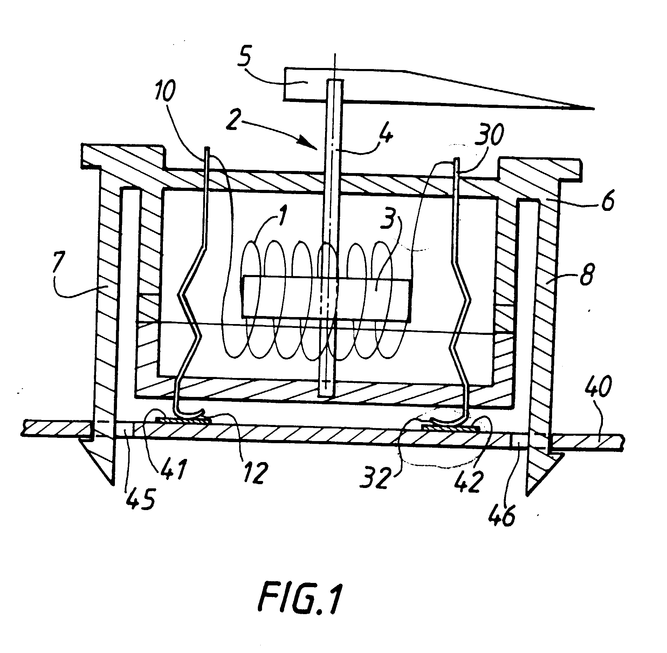

Le mouvement représenté sur la figure 1 est monté dans le tableau de bord d'une voiture et comporte un bobinage 1, ou stator, qui entraîne en rotation un rotor 2. Le rotor 2 est constitué d'un aimant 3 monté, dans le champ magnétique du stator 1, sur un axe 4 porté par un boîtier 6 du mouvement. L'axe 4 s'étend dans le plan de la figure 1 et porte en extrémité un index 5 ainsi entraîné en rotation devant un cadran non représenté.

Deux broches d'interface identiques 10, 30, électriquement conductrices, relient respectivement les deux extrémités du fil de bobinage 1 à deux plages 41, 42 de contact électrique d'une carte 40 de circuit imprimé portant le mouvement. Des pistes électriques non représentées relient les plages 41, 42 à un capteur commandant le mouvement.

Le boîtier 6 est, dans cet exemple, formé d'une partie inférieure solidaire d'une partie supérieure comportant quatre languettes élastiques d'encliquetage, dont seules deux, repérées 7 et 8, sont représentées. Les languettes 7, 8 comportent, à leur extrémité libre, des crocs qui coopèrent avec le bord de fenêtres 45, 46 de la carte 40 pour retenir le boîtier 6 en position sur la carte 40 et ainsi maintenir des zones de contact 12, 32 des broches 10, 30 en appui contre les plages de contact 41, 42 respectives de la carte 40.

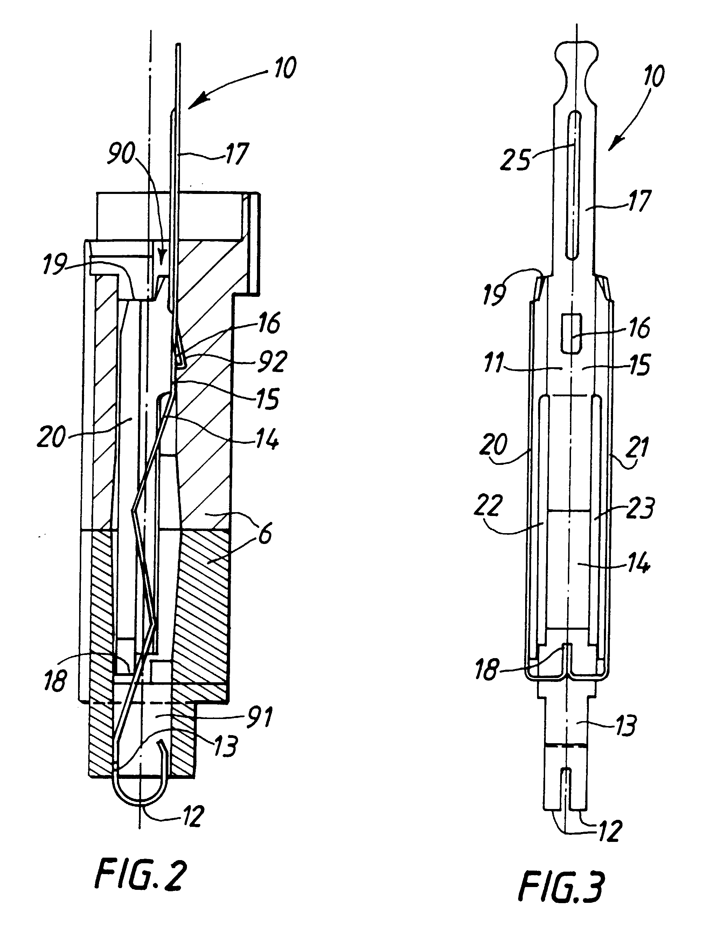

La constitution des broches 10, 30 va maintenant être précisée à l'aide des figures 2 et 3, qui représentent la broche 10.

La broche 10 présente dans cet exemple une symétrie par rapport à un plan 25 repéré sur la figure 3, qui est le plan de coupe de la figure 2. La broche 10 comporte une lame principale 11 encadrée par deux lames latérales 20 et 21.

La lame principale 11, sensiblement dans le plan 25, est constituée, dans l'ordre, par une partie d'extrémité recourbée 13 élastique, une portion 14 élastique à profil en ligne brisée, une portion 15 et une extrémité en forme de queue à souder 17.

L'extrémité recourbée 13 comporte, intégrée, la zone de contact 12, tandis que la queue à souder 17 reçoit une extrémité de fil du bobinage 1, qui y est soudée. Pour son assemblage au boîtier 6, la broche 10 est introduite dans son logement 90 du boîtier 6 à travers la partie inférieure du boîtier 6, jusqu'à ce qu'une butée 19 de la portion 15 bute contre une surface correspondante du boîtier 6 et bloque sa progression, ce qui empêche tout recul de la broche 10 et donc de la zone 12 par rapport à la carte 40. Découpé dans la portion 15 et en faisant saillie, un ergot élastique 16 est alors reçu dans une cavité 92 du boîtier 6 et empêche le retrait de la broche 10.

Les deux lames ou languettes latérales 20, 21, rattachées par une extrémité à la portion 15 de la lame 11, encadrent les portions centrales 14-15 et s'étendent perpendiculairement au plan 25.

Les lames 11, 20, 21 forment un ensemble à section transversale sensiblement en forme de U. Des fentes longitudinales 22 et 23 séparent la portion 14 des lames 20, 21 respectives. Les extrémités libres des lames 20, 21 sont repliées l'une contre l'autre devant la portion 14, à proximité de l'extrémité 13, pour former une butée 18.

Comme le montre la figure 2, la lame 11 a un profil en forme de ligne brisée dans sa portion 14 et forme ainsi un ressort qui s'oppose élastiquement au recul, dans la zone d'extrémité 91 du logement 90, de l'extrémité recourbée 13 de la lame 11 portant la zone 12. Ainsi, la portion 14 rappelle élastiquement la zone de contact 12 contre la plage 41 lorsque la zone 12 est appliquée contre celle-ci à l'aide des languettes 7, 8.

La butée 18, formée par les extrémités recourbées des lames 20 et 21 au contact, par leur tranche, de la lame 11, s'oppose aux déformations de la lame 11 en bout de la portion 14, à proximité de la zone 12.

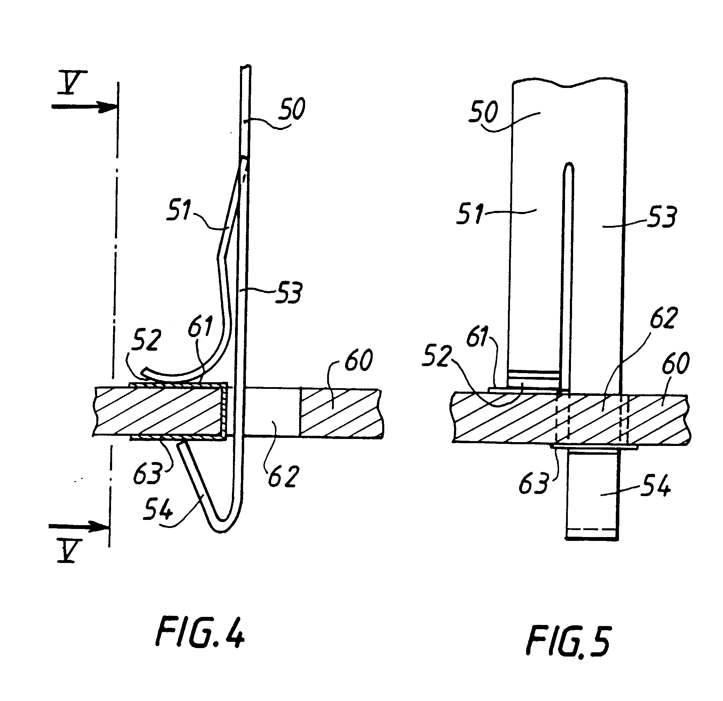

Dans le cas de la réalisation préférée des figures 4 et 5, les fonctions de fixation mécanique et de raccordement électrique du mouvement sont intégrées dans les broches d'interface.

La figure 4 est une vue latérale d'une broche 50 montée sur une carte 60 et la figure 5 est une vue correspondante selon le plan de coupe V-V de la figure 4.

La broche 50 de connexion électrique est fendue longitudinalement dans sa partie d'extrémité pour former deux languettes de longueurs inégales 51, 53. La languette 51, de forme sensiblement semblable à celle de la lame 11, porte une zone 52 venant en appui sur une plage de contact 61 de la carte 60 et présente une élasticité longitudinale s'opposant au recul de la zone 52.

La languette 53, rigide, se termine par un croc 54 traversant une fenêtre 62 de carte 60 et prenant appui sur la face de la carte 60 opposée à la plage 61. Dans cet exemple, l'extrémité du croc 54 assure aussi un contact électrique avec une plage 63 de la carte 60, reliée à la plage 61. Une fois le croc 54 en prise sur la plage 63, l'élasticité longitudinale de la languette 51 assure le pincement de la carte 60 entre la zone 52 et l'extrémité du croc 54, ce qui assure un contact électrique de bonne qualité.

On comprendra qu'il aurait pu être prévu d'autres moyens élastiques pour assurer le rappel des zones de contact des broches vers les plages de contact de la carte. Ce peuvent être, par exemple, des ressorts tendant à repousser des broches coulissantes vers la carte ou bien à rappeler les moyens de fixation du boîtier du mouvement et ainsi repousser le boîtier avec les broches vers la carte. De même, les broches peuvent assurer le raccordement électrique de composants électriques autres que le bobinage décrit dans cet exemple.

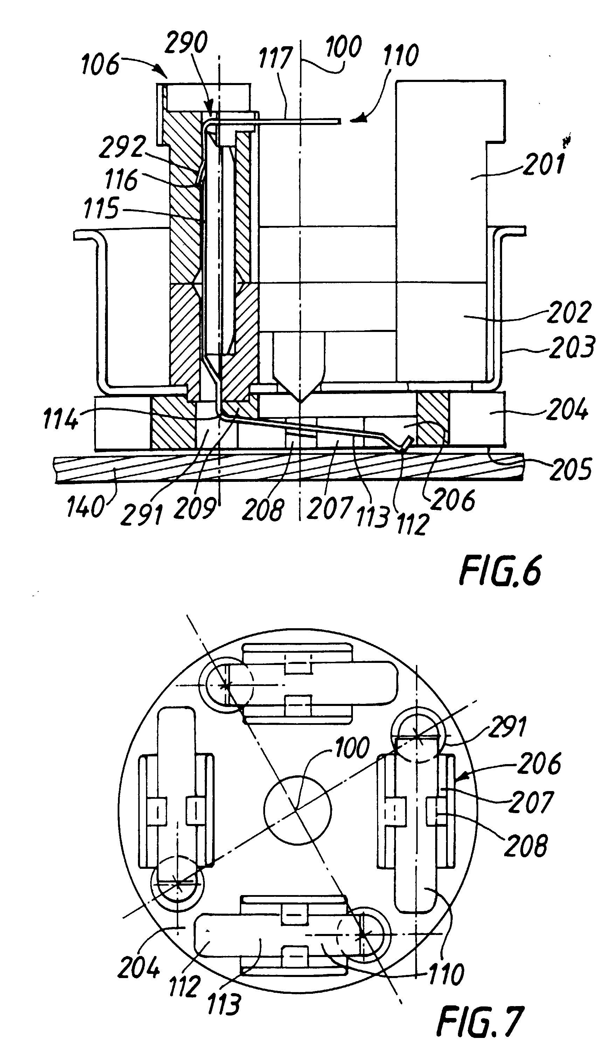

Le second exemple de réalisation des figures 6 et 7 présente une structure globalement semblable à celle du premier exemple ci-dessus et seules les différences en sont indiquées ci-après.

Le boîtier 106 comporte quatre secteurs présentant entre eux une symétrie axiale et dans chacun desquels est logée une broche d'interface 110 solidaire du boîtier 106 et écartée de 90 degrés des autres broches, autour de l'axe 100 du boîtier 106.

Chaque broche 110 diffère essentiellement de la broche 10 par le fait qu'il s'agit d'une simple lame et que l'élasticité voulue pour appliquer sa zone de contact 112 sur une carte de circuit imprimé 140 est obtenue au moyen d'une partie d'extrémité 113 formant ressort en porte-à-faux et repliée presque à angle droit par rapport à une partie centrale 115 rectiligne s'étendant parallèlement à l'axe 100. La partie 115 se prolonge par une partie d'extrémité en forme de queue à souder 117 qui peut être pliée à angle droit au-dessus du boîtier 106.

Le boîtier 106 est constitué de deux demi-carcasses assemblées, supérieure et inférieure, 201 et 202, et d'une coque 203 les entourant, montée sur une embase 204. Les moyens de fixation du boîtier 106 à la carte sont du même genre que ceux précédemment décrits et n'ont donc pas été représentés.

Le principe de montage des broches 110 dans le boîtier 106 est semblable à celui indiqué pour les broches 10. On glisse les broches 110, par leur extrémité 117, dans un logement 290 de la carcasse 201-202, puis on enfile la coque 203 et l'embase 204, par un passage 291, sur l'autre extrémité 113 des broches 110, pour ensuite effectuer deux étapes finales respectives de pliage des parties d'extrémité 113 et 117. Un ergot de verrouillage 116 de la partie 115 coopère avec une cavité 292 de la demi-carcasse supérieure 201 pour empêcher tout retrait de la lame 110 vers l'embase 204. En sens opposé, une butée 209 de l'embase 204 bloque le coude 114 reliant les parties 113 et 115 et empêche toute avancée supplémentaire de la lame 110 dans le logement 290 contenant la partie 115. L'ergot 116 et le coude 114 assurent ainsi, la solidarisation de l'empilage constitué des parties 201-204 du boîtier 106.

Les parties d'extrémité 113 occupent chacune, dans leur position repliée, un logement 206 réservé dans l'embase 204. La partie de contact 112 fait saillie sur la face 205 de montage de l'embase 204 sur la carte 140 et peut, au montage sur celle-ci, reculer vers l'intérieur du logement 206 contre l'action de la lame élastique 113 portant la partie de contact 112.

Il est ici prévu, dans le logement 206, une pièce de butée 207 associée à un clips 208 limitant la rotation de la partie d'extrémité 113 vers l'extérieur du logement 206 et évitant tout risque d'arrachement avant montage, tant que le clips 208 n'a pas été retiré. La pièce de butée 207 comporte une partie en queue d'aronde, non représentée, pour retenir provisoirement le clips 208.

## Revendications

1. Mouvement pour tableau de bord de véhicule, comportant un organe d'entraînement (4) d'un indicateur (5), relié électriquement à des broches d'interface (10, 30; 50; 110) raccordées à des moyens de connexion agencés pour connecter les broches à des plages de contact respectives (41, 42; 61, 63) d'une carte de circuit imprimé (40; 60), caractérisé par le fait que les moyens de connexion sont intégrés aux broches (50) et comportent des zones de contact (52, 54) agencées pour venir en appui sur lesdites plages (61, 63) et les broches (50) comportent des moyens d'accrochage (54) à la carte (60).

2. Mouvement selon la revendication 1, dans lequel les broches (50) sont agencées (51) pour rappeler élastiquement les zones de contact (52, 54) contre les plages respectives (61, 63).

3. Mouvement selon la revendication 2, dans lequel les moyens de connexion sont intégrés à une portion élastique des broches (50), en forme de lame (51, 53).

4. Mouvement selon la revendication 3, dans lequel les zones de contact (52) sont situées sur une extrémité recourbée des lames (51).

5. Mouvement selon la revendication 4, dans lequel la lame (51) forme un ressort en ligne brisée.

6. Mouvement selon la revendication 5, dans lequel les broches (10, 30) comportent chacune une butée (18) agencée pour s'opposer aux déformations de la lame en ligne brisée (14).

7. Mouvement selon l'une des revendications 3 et 4, dans lequel la lame (110) constitue une partie d'extrémité (113) de la broche (110), formant ressort en porte-à-faux.

8. Mouvement selon l'une des revendications 1 à 7, dans lequel des moyens d'encliquetage (7, 8), solidaires d'un boîtier (6) du mouvement et agencés pour coopérer avec des fenêtres (45, 46) de la carte (40; 60), sont prévus pour maintenir les zones de contact (12; 52) des broches (10, 30; 50) en appui contre les plages de contact (41; 61) de la carte (40; 60).

9. Mouvement selon la revendication 8, dans lequel les moyens d'encliquetage (7, 8; 51, 53) assurent un maintien élastique des zones de contact (12, 52).

10. Mouvement selon l'une des revendications 8 et 9, dans lequel le boîtier (6; 106) comporte des moyens de verrouillage (92; 209, 292) agencés pour coopérer avec des moyens correspondants (16; 114, 116) des broches (10, 30; 50; 110).

11. Mouvement selon la revendication 10, dans lequel les moyens de verrouillage (114, 116) des broches (110) sont agencés pour solidariser (209, 292) des éléments constitutifs (201-204) du boîtier (106).

12. Mouvement selon l'une des revendications 8 à 11, dans lequel le boîtier (6; 106) comporte des logements (91; 206) pour les broches (10, 30; 50; 110) agencés pour permettre un déplacement relatif des zones de contact (12, 32; 112) par rapport au boîtier (6; 106).

## Patentansprüche

1. Mechanismus für ein Armaturenbrett eines Kraftfahrzeugs, mit einem Antriebsorgan (4) für ein Anzeigeelement (5), das elektrisch mit Interface-Kontaktstifte (10, 30; 50; 110) verbunden ist, die an Verbindungsmittel angeschlossen sind, die dafür eingerichtet sind, mit den Stifte an jeweiligen Kontaktbereichen (41, 42; 61, 63) einer gedruckten Leiterplatte (40; 60) verbunden zu werden, dadurch gekennzeichnet, daß die Verbindungsmittel in die Stifte integriert sind und Kontaktzonen aufweisen, die dafür eingerichtet sind, auf den genannten Bereichen zur Anlage zu kommen, wobei die Stifte (50) Mittel (54) zum Verhaken mit der Karte (60) aufweisen. sen.

2. Mechanismus nach Anspruch 1, dadurch gekennzeichnet, daß die Stifte dafür eingerichtet sind (51), um die Kontaktzonen (52, 54) elastisch gegen die jeweiligen Bereiche (61, 63) anzudrücken.

3. Mechanismus nach Anspruch 2, dadurch gekennzeichnet, daß die Verbindungsmittel in einen elastischen, zungenförmigen (51,53) Abschnitt der Stifte integriert sind.

4. Mechanismus nach Anspruch 3, dadurch gekennzeichnet, daß sich die Kontaktzonen auf einem gekrümmten Endabschnitt der Zungen befinden.

5. Mechanismus nach Anspruch 4, dadurch gekennzeichnet, daß die Zunge (51) eine zickzackförmige Feder bildet.

6. Mechanismus nach Anspruch 5, dadurch gekennzeichnet, daß die Kontaktstifte (10, 30) jeweils einen Anschlag (18) aufweisen, um den Verformungen der Zunge in Zickzackform (14) entgegenzuwirken.

7. Mechanismus nach einem der Ansprüche 3 und 4, dadurch gekennzeichnet, daß die Zunge (110) einen Endabschnitt (113) des Kontaktstift (110) bildet, wodurch eine einseitig gelagerte Feder gebildet wird.

8. Mechanismus nach einem der Ansprüche 1 bis 7, dadurch gekennzeichnet, daß Einrastmittel (7, 8), die mit einem Gehäuse (6) des Mechanismus fest verbunden und dafür eingerichtet sind, mit Fenstern (45, 46) der Leiterplatte (40; 60) zusammenzuwirken, vorgesehen sind, um die Kontaktzonen (12; 52) der Kontaktstifte (10, 30; 50) andrückend gegen die Kontaktbereiche (41, 61) der Leiterplatte (40; 60) zu halten.

9. Mechanismus nach Anspruch 8, dadurch gekennzeichnet, daß die Einrastmittel (7, 8; 51, 53) einen elastischen Halt der Kontaktbereiche (12; 52) gewährleisten.

10. Mechanismus nach einem der Ansprüche 8 und 9, dadurch gekennzeichnet, daß das Gehäuse (6; 106) Verriegelungsmittel (92; 209, 292) aufweist, die zum Zusammenwirken mit entsprechenden Mitteln (16; 114, 116) der Kontaktstifte (10, 30; 50; 110) eingerichtet sind.

11. Mechanismus nach Anspruch 10, dadurch gekennzeichnet, daß die Verriegelungsmittel (114, 116) der Kontaktstifte (110) zum Susammemhalten (209; 292) der das Gehäuse (106) bildenden Elemente (201 bis 204) eingerichtet sind.

12. Mechanismus nach einem der Ansprüche 8 bis 11, dadurch gekennzeichnet, daß das Gehäuse (6; 106) Aufnahmeräume (91; 206) für die Kontaktstifte (10, 30; 50; 110) aufweist, die dazu eingerichtet sind, eine relative Verlagerung der Kontaktzonen (12, 32; 112) in Bezug auf das Gehäuse (6; 106) zu ermöglichen.

## Claims

1. Movement for a vehicle dashboard, comprising a driving member (4) for an indicator (5), electrically connected to interface pins (10, 30; 50; 110) which are connected to connection means arranged to connect the pins to respective contact pads (41, 42; 61, 63) of a printed circuit board (40; 60), characterised in that the connection means are integrated in the pins (50) and comprise contact zones (52, 54) arranged to bear on the said pads (61, 63), and the pins (50) comprise means (54) for anchorage to the board (60).

2. Movement according to claim 1, wherein the pins (50) are arranged (51) to brace the contact zones (52, 54) elastically against the respective pads (61, 63).

3. Movement according to claim 2, wherein the connection means are integrated into an elastic portion of the pins (50), in the form of a blade (51, 53).

4. Movement according to claim 3, wherein the contact zones (52) are located on a curved end of the blades (51).

5. Movement according to claim 4, wherein the blade (51) forms a spring formed as a broken line.

6. Movement according to claim 5, wherein the pins (10, 30) each comprise a stop (18) arranged to oppose deformations of the blade which is formed as a broken line (14).

7. Movement according to one of claims 3 and 4, wherein the blade (110) constitutes an end part (113) of the pin (110) forming a protruding spring.

8. Movement according to one of claims 1 to 7, wherein snap-fit means (7, 8), fixedly attached to a casing (6) of the movement and arranged to cooperate with windows (45, 46) in the board (40; 60), are provided to keep the contact zones (12; 52) of the pins (10, 30; 50) bearing against the contact pads (41; 61) of the board (40; 60).

9. Movement according to claim 8, wherein the snap-fit means (7, 8; 51, 53) ensure elastic holding of the contact zones (12, 52).

10. Movement according to one of claims 8 and 9, wherein the casing (6; 106) comprises locking means (92; 209, 292) arranged to cooperate with corresponding means (16; 114, 116) of the pins (10, 30; 50; 110).

11. Movement according to claim 10, wherein the locking means (114, 116) of the pins (110) are arranged to fixedly attach (209, 292) constituent elements (201-204) of the casing (106).

12. Movement according to one of claims 8 to 11, wherein the casing (6; 106) comprises housings (91; 206) for the pins (10, 30; 50; 110) arranged to permit a relative displacement of the contact zones (12, 32; 112) with respect to the casing (6; 106).
